# EUROPÄISCHE PATENTSCHRIFT

(11) **EP 0 779 712 B1**
(45) Veröffentlichungstag und Bekanntmachung des Hinweises auf die Patenterteilung: **12.05.1999**
(21) Anmeldenummer: 96119583.1
(22) Anmeldetag: 06.12.1996
(51) Int. Cl.: H03K 17/96

(54) **Mikrocontrollerschaltung für ein Haushaltsgerät**
Microcontroller for a household appliance
Micro-contrôleur pour un appareil ménager

(30) Priorität: 12.12.1995 DE 19546323
(43) Veröffentlichungstag der Anmeldung: 18.06.1997
(73) Patentinhaber: Diehl Stiftung & Co., 90478 Nürnberg (DE)
(72) Erfinder: Fluhrer, Henry, 90489 Nürnberg (DE); Hammelsbacher, Karlheinz, 91126 Schwabach (DE)

(56) Entgegenhaltungen:
- EP-A- 0 023 271
- EP-A- 0 093 565
- PATENT ABSTRACTS OF JAPAN vol. 012, no. 210 (P-717), 16.Juni 1988 & JP 63 008801 A (FUJI PHOTO FILM CO LTD), 14.Januar 1988,
- PATENT ABSTRACTS OF JAPAN vol. 009, no. 305 (E-363), 3.Dezember 1985 & JP 60 142609 A (FUJITSU KK), 27.Juli 1985,

## Beschreibung

Die Erfindung betrifft eine Mikrocontrollerschaltung zur Steuerung der Funktionen eines Haushaltsgeräts, insbesondere eines Glaskeramik-Kochherdes, mit mehreren auf Berührung ansprechenden Sensorelementen, insbesonder Infrarot-Sensorelementen oder kapazitiven Sensorelementen.

Es ist bekannt, die Funktionen von Haushaltsgeräten mittels Berührungssensoren zu steuern. Ein kapazitives Sensorelement hierfür ist in der DE 38 44 392 A1 beschrieben.

Bei einem Kochherd mit einer Glaskeramikplatte lassen sich die Berührungssensoren, beispielsweise Infrarot-Sensorelemente oder kapazitive Sensorelemente, mit der Glaskeramikplatte integrieren.

Die Sensorelemente wirken auf eine Steuerelektronik. Aufgrund der Einbaulage, Bauteiltoleranzen und/oder Eigenheiten der Glaskeramikplatte ist damit zu rechnen, daß die Sensorelemente bei gleicher Betätigung Ausgangssignale abgeben, die voneinander abweichen. Dies ist ungünstig, weil die Steuerelektronik, insbesondere Mikrocontrollerschaltung, ein normiertes Eingangssignal verlangt. Die Sensorelemente einzeln abzugleichen, ist aufwendig.

Eine Mikrocontrollerschaltung gemäß dem Oberbegriff des Anspruchs 1 ist aus Patent Abstracts of Japan, vol. 9, no. 305 (E-363) (JP-A-60 142609) bekannt.

Aufgabe der Erfindung ist es, bei einer Mikrocontrollerschaltung gemäß dem Oberbegriff des Anspruchs 1 einen einfachen Abgleich der Sensorsignale zu schaffen.

Erfindungsgemäß ist obige Aufgabe dadurch gelöst, daß in dem Speicher jedem Sensorelement zwei Abgleichfaktoren zugeordnet sind, daß der Verstärker das analoge Ausgangssignal des jeweiligen Sensorelements mit dem ersten Abgleichfaktor grob bis in die Nähe eines Normierungswertes verstärkt und daß nach einer Analog/Digital-Wandlung des so verstärkten Ausgangssignals das binär gewandelte Ausgangssignal mit dem ihm zugeordneten zweiten Abgleichfaktor multipliziert wird, um es auf einen für alle Sensorelemente gleichen Normierungswert zu bringen.

Dadurch ist erreicht, daß die Mikrocontrollerschaltung von allen Sensorelementen bei gleicher Betätigung ein gleichstarkes Eingangssignal erhält, auch wenn die Ausgangssignale der Sensoren aus irgendwelchen Gründen an sich unterschiedlich hoch sind.

Durch die Aufteilung der bis zum Erreichen des Normierungswertes nötigen Verstärkung auf die ersten und zweiten Abgleichfaktoren hält sich der zusätzliche Hardware-Aufwand in einfach realisierbaren Grenzen. Ein weiterer Vorteil besteht darin, daß ein weiter Aussteuerbereich erreichbar ist.

Für die ersten Abgleichfaktoren genügt ein Analogverstärker mit wenigen, beispielsweise 8 Stufen. Die zweiten Abgleichfaktoren können im Mikrocontroller softwaremäßig verarbeitet werden.

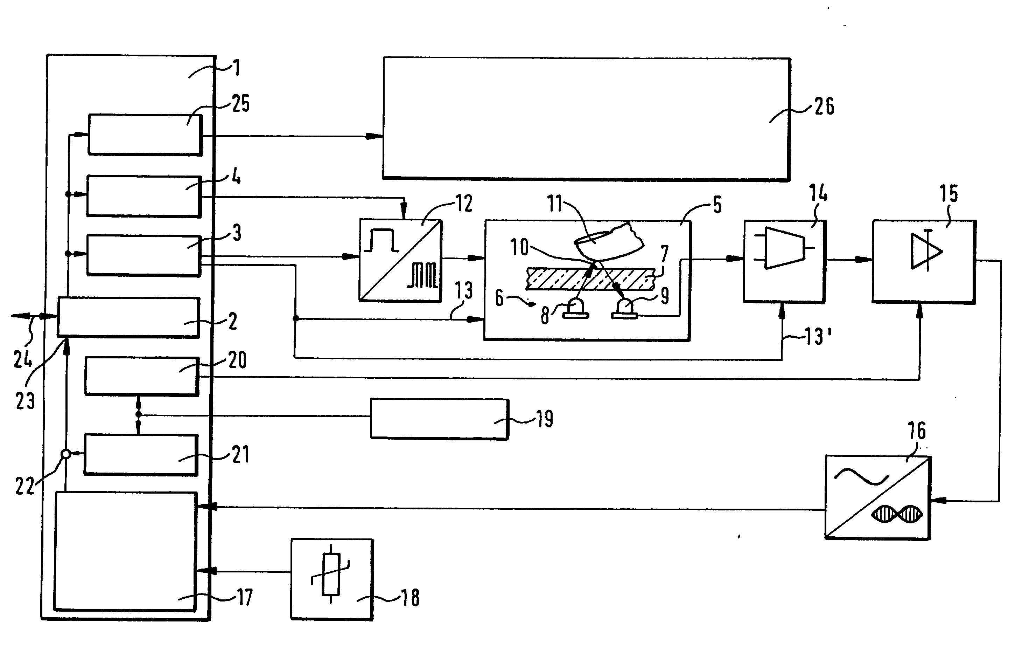

Weitere vorteilhafte Ausgestaltungen der Erfindung ergeben sich aus den Unteransprüchen und der folgenden Beschreibung eines Ausführungsbeispiels, das mit Infrarot-Sensorelementen arbeitet, wobei jedoch auch kapazitive Sensorelemente vorgesehen sein könnten. Die Figur zeigt einen Signalflußplan einer Mikrocontrollerschaltung eines Glaskeramik-Kochherdes.

Ein Mikrocontroller(1) umfaßt außer einer zentralen Prozessoreinheit(2) (CPU) eine Tastaturansteuerung(3) und eine Modulationsfrequenzerzeugung(4) für eine Tastatur(5), die mehrere Infrarot-Sensorelemente(6) aufweist, von denen in der Figur eines dargestellt ist.

Die Sensorelemente(6) sind unter einer Glaskeramikplatte (7) eines Kochherdes angeordnet. Sie weisen eine Sendediode(8) und eine Empfangsdiode(9) auf. Wird die Stelle(10) der Glaskeramikplatte(7) mit einem Finger(11) berührt, dann wird das Signal der Sendediode(8) auf die Empfangsdiode(9) reflektiert.

Die Tastaturansteuerung(3) gibt ein Signal an einen Modulator(12), von dem dieses mit der Modulationsfrequenz gepulst und an eine der Sendedioden(8) gelegt wird. Über eine Steuerleitung(13) der Tastaturansteuerung(3) wird das Sendesignal zyklisch wechselnd an alle Sendedioden(8) gelegt.

Die analogen Ausgangssignale der Empfangsdiode(9) sind über einen Multiplexer(14) an einen mehrstufigen Analogverstärker(15) gelegt. Der Multiplexer(14) ist von der Tastaturansteuerung(3) über eine Leitung(13') zur Zuordnung der Sensorelemente(6) zum jeweiligen Ausgangssignal gesteuert.

Dem Verstärker(15) ist ein Demodulator(16) nachgeschaltet, der ausgangsseitig an einem Eingang eines Analog/Digital-Wandlers(17) liegt, der eine Funktionsgruppe des Mikrocontrollers(1) sein kann. Am Eingang des Analog/Digital-Wandlers(17) liegen somit die analogen, verstärkten Ausgangssignale der Sensorelemente (6) multiplex an. An einen weiteren Eingang des Wandlers (17) ist ein Temperaturfühler(18) angeschlossen, über den die Temperaturabhängigkeit der Signale der Infrarot-Sensorelemente(6) kompensiert wird.

Dem Mikrocontroller(1) ist ein Schreib-Lesespeicher(19) (EEPROM) zugeordnet, in dem für das Ausgangssignal jedes Sensorelements(6) zwei Abgleichfaktoren abgelegt sind.

Jeweils der erste Abgleichfaktor wird über eine Signalverstärkung(20) des Mikrocontrollers(1) an den Verstärker(15) gelegt. Dabei ist sichergestellt, daß jedem der beispielsweise 16 Ausgangssignale der beispielsweise 16 Sensorelemente ein erster Abgleichfaktor zugeordnet ist, so daß jedes Sensor-Ausgangssignal mit einem bestimmten Faktor analog verstärkt wird, wobei der jeweilige Abgleichfaktor gleich oder anders sein wird, wie der einem anderen Sensorelement zugeordnete erste Abgleichfaktor.

Es sind nur wenige, beispielsweise 8, Abgleichfaktoren vorgesehen. Dementsprechend genügt ein geringstufiger, beispielsweise achtstufiger, Verstärker(15). Ein solcher ist baulich einfach zu realisieren. Allerdings ist mit wenigen unterschiedlichen Abgleichfaktoren nur eine grobe Annäherung der verstärkten Ausgangssignale an einen gewünschten, für alle Sensor-Ausgleichssignale gleichen, Normierungswert zu erreichen. Die ersten Abgleichfaktoren haben ganzzahlige, positive Werte.

Im Speicher(19) ist für jedes Sensorelement(6) ein zweiter Abgleichfaktor abgelegt. Dieser wirkt über eine Schaltpegelanpassung(21) des Mikrocontrollers(1) auf einen Multiplikationspunkt(22) des Mikrocontrollers(1), der softwaremäßig realisiert ist und logisch am Ausgang des Wandlers(17) liegt, wobei an diesem Ausgang die Ausgangssignale der einzelnen Sensorelemente(6) binär gewandelt vorliegen. Die binär gewandelten Ausgangssignale der einzelnen Sensorelemente(6) werden mit dem jeweils zugeordneten zweiten Abgleichfaktor multipliziert, so daß am Tastatureingang(23) der zentralen Prozessoreinheit(2) alle Ausgangssignale betätigter Sensorelemente den gleichen Normierungswert haben. Die zweiten Abgleichfaktoren sind so gewählt, daß sie das vom Verstärker(15) grob vorverstärkte jeweilige Ausgangssignal auf den Normierungswert bringen.

Vorzugsweise ist der erste Abgleichfaktor logarithmisch geteilt, wobei der jeweils nächsthöhere erste Abgleichfaktor den doppelten Wert des nächstniedrigen ersten Abgleichfaktors hat, nämlich beispielsweise 1,2,4,8,16... . Es ist dadurch mit vergleichsweise wenigen Verstärkungsstufen des Verstärkers(15) ein großer Aussteuerbereich erreicht. Im Speicher(19) genügt für den ersten Abgleichfaktor (Verstärkungsfaktor) eine Breite von 4 Bit und für den zweiten Abgleichfaktor (Multiplikationsfaktor) genügt ebenfalls eine Breite von 4 Bit. Es genügt also insgesamt im Speicher(19) und bei der Verarbeitung 1 Byte pro Sensorelement(6).

Der Mikrocontroller(1) ist an einer Schnittstelle(24) mit der nicht näher dargestellten Einrichtung verbunden, die mittels der Sensorelemente(6) der Tastatur(5) schaltbar sind. Der Mikrocontroller(1) weist eine Displayansteuerung(25) für eine Betriebszustands-Anzeige (26) auf.

Das Einlesen der ersten und zweiten Abgleichfaktoren in den Speicher(19) kann durch den Mikrocontroller(1) selbst menügesteuert erfolgen. Hierfür wird eine handelsübliche Graukarte auf die Tastatur(5) gelegt. Der Mikrocontroller (1) ermittelt dann für jedes Sensorelement(6) den ersten und zweiten Abgleichfaktor, der nötig ist, um den Normierungswert am Tastatureingang(23) zu erreichen. Dabei gehen die Eigenheiten der jeweiligen Glaskeramikplatte, Lagetoleranzen und Bauteiltoleranzen der Sensorelemente(6) in die Abgleichfaktoren ein. Es ist möglich, den Abgleich vorzunehmen, nachdem die Sensorelemente(6) an der Glaskeramikplatte(7) installiert sind. Der Abgleichvorgang kann auch nach einer gewissen Betriebszeit wiederholt werden, um die Abgleichfaktoren an neue, beispielsweise alterungsbedingte, Verhältnisse anzupassen. Der Abgleichvorgang kann an der Anzeige(26) verfolgt werden.

## Patentansprüche

1. Mikrocontrollerschaltung zur Steuerung der Funktionen eines Haushaltsgeräts, insbesondere Glaskeramik-Kochherd, mit mehreren auf Berührung ansprechenden Sensorelementen, insbesondere Infrarot-Sensorelementen oder kapazitiven Sensorelementen, einem Speicher (19) zum Speichern von den Sensorelementen (6) zugeordneten Abgleichfaktoren und einem vom Speicher (19) gesteuerten Verstärker (15),
dadurch gekennzeichnet,
daß in dem Speicher(19) jedem Sensorelement(6) zwei Abgleichfaktoren zugeordnet sind, daß der Verstärker (15) das analoge Ausgangssignal des jeweiligen Sensorelements (6) mit dem ersten Abgleichfaktor grob bis in die Nähe eines Normierungswertes verstärkt und daß nach einer Analog/ Digital-Wandlung des so verstärkten Ausgangssignals das binär gewandelte Ausgangssignal mit dem ihm zugeordneten zweiten Abgleichfaktor multipliziert wird, um es auf einen für alle Sensorelemente gleichen Normierungswert zu bringen.

2. Mikrocontrollerschaltung nach Anspruch 1,
dadurch gekennzeichnet,
daß die Ausgangssignale der Sensorelemente(6) multiplex dem Verstärker (15) zugeführt sind, der die ersten Abgleichfaktoren verarbeitet.

3. Mikrocontrollerschaltung nach Anspruch 1 oder 2,
dadurch gekennzeichnet,
daß der Verstärker(15) in, beispielsweise 8, Stufen schaltbar ist, wobei der dem jeweiligen Sensorelement(6) zugeordnete erste Abgleichfaktor an den Verstärker(15) gelegt ist.

4. Mikrocontrollerschaltung nach einem der vorhergehenden Ansprüche,
dadurch gekennzeichnet, daß die ersten Abgleichfaktoren logarithmisch gestuft sind.

5. Mikrocontrollerschaltung nach einem der vorhergehenden Ansprüche,
dadurch gekennzeichnet,
daß der Mikrocontroller(1) das binär gewandelte, verstärkte Ausgangssignal des jeweiligen Sensorelements (6) mit dem zugeordneten zweiten Abgleichfaktor softwaremäßig multipliziert.

6. Mikrocontrollerschaltung nach einem der vorhergehenden Ansprüche,
dadurch gekennzeichnet,
daß der Mikrocontroller(1) ein Abgleichprogramm enthält, das nach Auflegen einer Graukarte auf alle Sensorelemente (6) die jeweils nötigen ersten und zweiten Abgleichfaktoren ermittelt und im Speicher(19) ablegt.

## Claims

1. Microcontroller circuit for controlling the functions of a domestic appliance, in particular a glass ceramic cooker, having several sensor elements which are responsive to touch, in particular infrared sensor elements or capacitive sensor elements, a memory (19) for storing adjustment factors allocated to the sensor elements (6) and an amplifier (15) controlled by the memory (19),
characterized in that,
in the memory (19), two adjustment factors are allocated to each sensor element (6),
in that the amplifier (15) boosts the analogue output signal of the respective sensor element (6) with the first adjustment factor to roughly in the neighbourhood of a standardization value and
in that, after an analogue/digital conversion of the output signal thus boosted, the binary converted output signal is multiplied by the second adjustment factor allocated to it to bring it to a similar standardization value for all the sensor elements.

2. Microcontroller circuit according to Claim 1,
characterized in that
the output signals of the sensor elements (6) are delivered multiplexly to the amplifier (15) which processes the first adjustment factors.

3. Microcontroller circuit according to Claim 1 or 2,
characterized in that
the amplifier (15) can be switched for example in 8 stages, the first adjustment factor allocated to the respective sensor element (6) being delivered to the amplifier (15).

4. Microcontroller circuit according to one of the preceding claims,
characterized in that
the first adjustment factors are graduated logarithmically.

5. Microcontroller circuit according to one of the preceding claims,
characterized in that,
by means of software, the microcontroller (1) multiplies the binary converted, boosted output signal of the respective sensor element (6) by the second allocated adjustment factor.

6. Microcontroller circuit according to one of the preceding claims,
characterized in that
the microcontroller (1) includes an adjustment programme which, after placing of a grey chart on all the sensor elements (6), determines the first and second adjustment factors necessary in each case and stores them in the memory (19).

## Revendications

1. Circuit de microcontrôleur, pour la commande des fonctions d'un appareil ménager, en particulier d'une cuisinière à vitrocéramique, comportant plusieurs éléments sensibles réagissant au contact, en particulier des éléments sensibles à infrarouge ou des éléments sensibles capacitifs, une mémoire (19) pour la mémorisation de facteurs d'égalisation associés aux éléments sensibles (6) ainsi qu'un amplificateur (15) commandé par la mémoire (19), caractérisé en ce que dans la mémoire (19) deux facteurs d'égalisation sont associés à chaque élément sensible (6), en ce que l'amplificateur amplifie grossièrement le signal de sortie analogique de chaque élément sensible (6), avec le premier- facteur d'égalisation, jusqu'à proximité d'une valeur de normalisation et en qu'après une conversion analogique/numérique du signal de sortie ainsi amplifié, le signal de sortie converti de manière binaire est multiplié par le deuxième facteur d'égalisation qui lui est affecté, afin de l'amener à une même valeur de normalisation pour tous les éléments sensibles.

2. Circuit de microcontrôleur selon la revendication 1, caractérisé en ce que les signaux de sortie des éléments sensibles (6) sont acheminés par multiplexage à l'amplificateur (15), qui traite les premiers facteurs d'égalisation.

3. Circuit de microcontrôleur selon la revendication 1 ou 2, caractérisé en ce que l'amplificateur (15) est commandable par échelons, par exemple huit, le premier facteur d'égalisation associé à l'élément sensible (6) respectif étant appliqué à l'amplificateur (15).

4. Circuit de microcontrôleur selon l'une des revendications précédentes, caractérisé en ce que les premiers facteurs d'égalisation sont échelonnés de manière logarithmique.

5. Circuit de microcontrôleur selon l'une des revendications précédentes, caractérisé en ce que le microcontrôleur (1) multiplie, au moyen du logiciel, le signal de sortie amplifié, converti de manière binaire, de l'élément sensible (6) respectif par le deuxième facteur d'égalisation correspondant.

6. Circuit de microcontrôleur selon l'une des revendications précédentes, caractérisé en ce que le microcontrôleur (1) contient un programme d'égalisation, qui, après application d'une carte de gris sur tous les éléments sensibles (6), détermine les premiers et deuxièmes facteurs d'égalisation nécessaires dans chaque cas et les stocke dans la mémoire (19).
